# EUROPEAN PATENT APPLICATION

(11) **EP 1 667 234 A2**
(43) Date of publication of application: **07.06.2006**
(21) Application number: 05105804.8
(22) Date of filing: 29.06.2005
(51) Int. Cl.: H01L 27/32, H01L 27/15

(54) **Light emitting display device**

(30) Priority: 02.07.2004 KR 2004051524
(71) Applicant: Samsung SDI Co., Ltd., Suwon-si Gyeonggi-do (KR)
(72) Inventor: Chae, Byung-Hoon, Gyeonggi-do (KR); Kim, Seon-Hee, Gyeonggi-do (KR); Nam, Wi-Jin, Gyeonggi-do (KR)
(74) Representative: Hengelhaupt, Jürgen

(57) **Abstract**

A light emitting display device including a substrate, an emission unit that forms an image and is disposed on the substrate, a plurality of terminals contacting a plurality of interconnecting lines electrically connected to the emission unit, and a contact resistance controlling portion which decreases a contact resistance between a terminal and an interconnecting line and is disposed where the terminal contacts the interconnecting line.

## Description

### CROSS-REFERENCE TO RELATED PATENT APPLICATION

This application claims priority to and the benefit of Korean Patent Application No. 10-2004-0051524, filed on July 2, 2004, which is hereby incorporated by reference for all purposes as if fully set forth herein.

### BACKGROUND OF THE INVENTION

### Field of the Invention

The present invention relates to a light emitting display device, and more particularly, to a light emitting display device having decreased contact resistance between an interconnecting line and a terminal.

### Discussion of the Background

Generally, self-emissive light emitting display devices have many advantages. For example, they may have wide viewing angles, excellent contrast, and high response speed. Due to these advantages, self-emissive light emitting display devices are regarded as next generation display devices. Light emitting display devices may be inorganic or organic devices depending upon the material comprising their emission layer. Generally, organic light emitting display devices are brighter and they respond quicker than inorganic light emitting display devices. Additionally, organic light emitting display devices can form color images. Hence, active research is being conducted into organic light emitting display devices.

A light emitting display device may include an anode, an emission layer, a cathode, and the like. The anode may be formed in a predetermined pattern on a transparent insulating substrate, such as a glass substrate. Then, an organic or inorganic layer may be disposed on the anode, thus forming the emission layer. The cathode may then be formed in a predetermined pattern on the emission layer. The cathode is disposed substantially perpendicular to the anode.

The emission layer may be interposed between a hole transport layer and an electron transport layer.

The light emitting display device forms an image as follows. Applying a voltage to the anode and the cathode injects holes from the anode to the emission layer through a hole transport layer and injects electrons from the cathode to the emission layer through an electron transport layer. The holes and electrons recombine in the emission layer, thus generating excitons. Then, the excitons drop from an exited state to a ground state, thereby causing luminous molecules of the emission layer to emit light, thus forming an image.

Hereinafter, organic light emitting display devices will be described.

The organic light emitting display device includes an organic emission unit, which forms an image and may be disposed on a transparent substrate. A cap covers and seals the organic emission unit and contacts the transparent substrate. In this case, an electrode terminal group, which applies a predetermined voltage or a signal to the organic emission unit, extends outside of the cap and may be connected to a flexible printed circuit board on which a circuit is mounted.

The organic emission unit may include a first electrode line, a second electrode line facing the first electrode line, and an organic layer, which includes at least an emission layer, disposed between the first electrode line and the second electrode line. With this structure, a portion of the organic layer formed above an edge of the first electrode line can be very thin, which may cause a short circuit between the first electrode line and the second electrode line. Additionally, the short-circuit can occur among the first electrode lines.

In order to prevent such short-circuits, an inner insulator may be formed among the first electrode lines, which is disclosed in US Patent Nos. 6,222,315 and 6,297,589. In particular, the inner insulator disclosed in US Patent No. 6,222,315 may gradually thin toward an adjacent electrode line. Therefore, short-circuits can be prevented at the boundary between adjacent electrode lines.

The first electrode line and the second electrode line may be connected to a first electrode terminal group and a second electrode terminal group, respectively, of an electrode terminal group. In this case, steps formed between the first and second electrode terminal groups and a surface of a substrate may cause an electric short at junctions of the first and second electrode lines and the first and second electrode terminal groups.

U.S. Patent Application Publication No. US 2004/0108809 A1 discloses an organic light emitting display device, as shown in FIG. 1 and FIG. 2, to solve this problem.

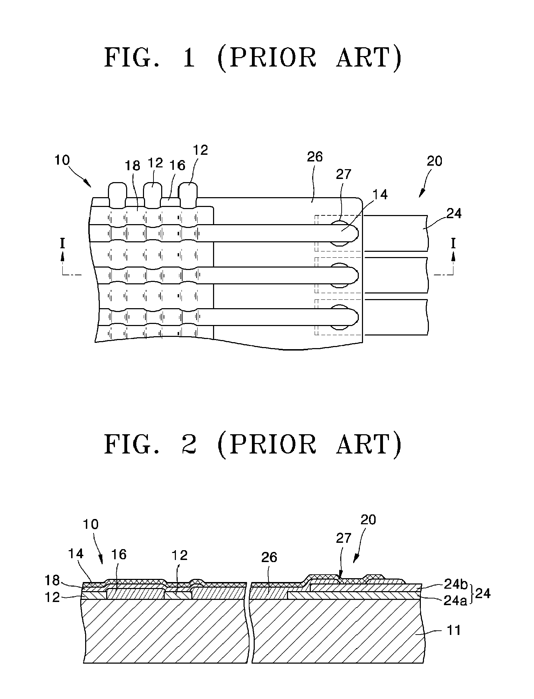

Referring to FIG. 1 and FIG. 2, first electrode lines 12 and second electrode lines 14 are disposed perpendicular to each other on a substrate 11, and an organic layer 18 is interposed between the first electrode lines 12 and the second electrode lines 14. The second electrode lines 14 are connected to second electrode terminals 24 of a second electrode pad portion 20. Inter-insulating layers 16 are disposed between the first electrode lines 12.

The second electrode terminals 24 include a first terminal 24a, which may be formed of a conducting oxide layer, and a second terminal 24b, which may be formed of a metal layer. An insulating layer 26, which includes a contact hole 27, may be formed on the second electrode terminal 24.

Outside an emission unit 10, the second electrode line 14 may be formed on the insulating layer 26, and it contacts the second electrode terminal 24 through the contact hole 27.

The first terminal 24a and the first electrode line 12 may be made of indium tin oxide (TTO), and the second terminal 24b may be made of a highly conductive material, such as Cr or Ag, such that a decrease of a voltage due to a line resistance of the first terminal 24a can be prevented.

However, at a portion of the second terminal 24b exposed by the contact hole 27, a contact resistance between the second electrode line 14 and the second terminal 24b may increase and be non-uniform. This is because the portion of the second terminal 24b exposed by the contact hole 27 may be contaminated by an organic or inorganic material used in the manufacturing process. The contamination of the second terminal 24b may not be completely prevented by UV washing or oxygen plasma cleansing.

The increase and non-uniformity of the contact resistance between the second electrode line 14 and the second terminal 24b may result in a high driving voltage in the corresponding line. Further, images may be formed with random black spots.

### SUMMARY OF THE INVENTION

The present invention provides an electroluminescent device with a low contact resistance where an interconnecting line contacts a terminal, thus decreasing a driving voltage and obtaining more uniform signals.

Additional features of the invention will be set forth in the description which follows, and in part will be apparent from the description, or may be learned by practice ofthe invention.

The present invention discloses a light emitting display device including a substrate, an emission unit which forms an image and is disposed on the substrate, a first conductor which contacts a second conductor that is electrically connected to the emission unit, and a contact resistance controlling portion which decreases a contact resistance between the first conductor and the second conductor and is disposed where the first conductor contacts the second conductor.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles ofthe invention.

FIG. 1 is a plan view showing a portion of a conventional organic light emitting display device.

FIG. 2 is a sectional view taken along line I-I of FIG. 1.

FIG. 3 is an exploded perspective view showing an organic light emitting display device according to an exemplary embodiment of the present invention.

FIG. 4 is an enlarged plan view of a contact resistance controlling portion "A" of FIG. 3 according to an exemplary embodiment of the present invention before forming a second electrode line.

FIG. 5 shows FIG. 4 after forming the second electrode line.

FIG. 6 is a sectional view taken along line II-II of FIG. 5.

FIG. 7 is an enlarged plan view of a contact resistance controlling portion "A" of FIG. 3 according to an exemplary embodiment of the present invention before forming a second electrode line.

FIG. 8 shows FIG. 7 after forming the second electrode line.

FIG. 9 is a sectional view taken along line III-III of FIG. 8.

FIG. 10 an enlarged plan view of a contact resistance controlling portion "A" of FIG. 3 according to an exemplary embodiment of the present invention before forming a second electrode line.

FIG. 11 shows FIG. 10 after forming the second electrode line.

FIG. 12 is a sectional view taken along line IV-IV of FIG. 11.

### DETAILED DESCRIPTION OF THE ILLUSTRATED EMBODIMENTS

The present invention will now be described more fully with reference to the accompanying drawings showing exemplary embodiments of the present invention. Exemplary embodiments of the present invention relate to organic light emitting display devices including an organic emission layer. However, techniques according to the present invention can also be used to form inorganic light emitting display devices including an inorganic emission layer.

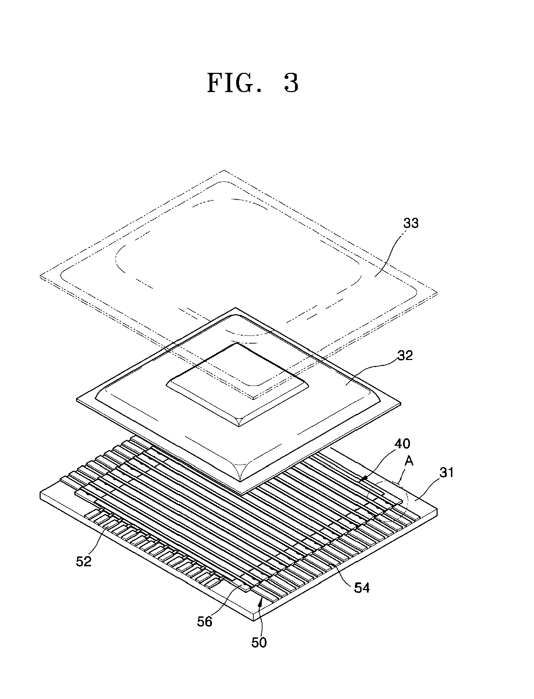

FIG. 3 is an exploded perspective view showing an organic light emitting display device according to an exemplary embodiment ofthe present invention.

Referring to FIG. 3, the organic light emitting display device according to an exemplary embodiment of the present invention may include a substrate 31, an emission unit 40, which forms an image and may be disposed on an upper surface of the substrate 31, a sealing element 32, which seals the emission unit 40 with the substrate 31, and terminals 50 applying a current to the emission unit 40 and extending outside the sealing element 32. The terminals 50 exposed outside the sealing element 32 may be connected to a flexible printed circuit board 33 on which a circuit unit (not shown) is mounted to drive the emission unit 40. This structure can be used in the following exemplary embodiments of the present invention.

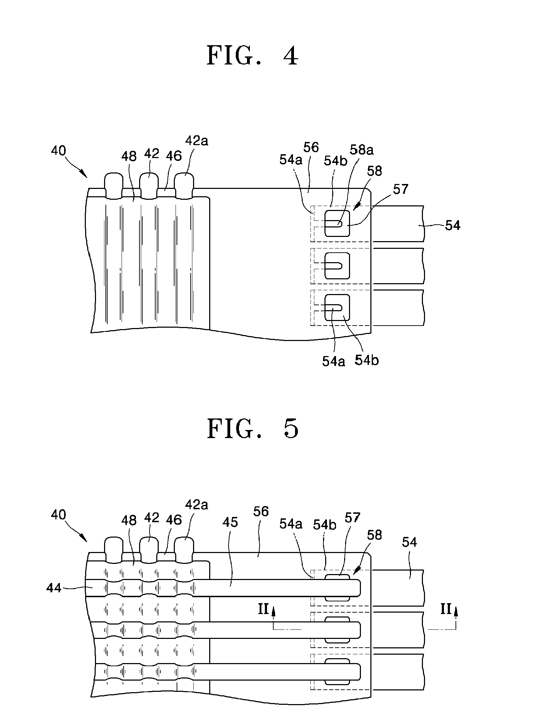

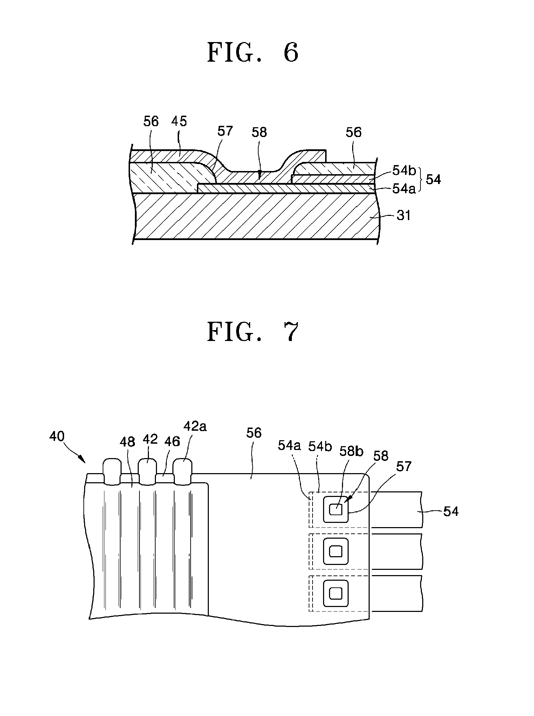

The organic light emitting display device according to an embodiment ofthe present invention will now be described in detail with reference to FIG. 4, FIG. 5 and FIG. 6. FIG. 4 is an enlarged plan view of a contact resistance controlling portion "A" of FIG. 3 according to an embodiment of the present invention before forming a second electrode line. FIG. 5 shows FIG. 4 after forming the second electrode line, and FIG. 6 is a sectional view taken along line II-II of FIG. 5.

Referring to FIG. 3, FIG. 4, FIG. 5 and FIG. 6, the emission unit 40 may include a plurality of first electrode lines 42 arranged in a predetermined pattern and formed on the substrate 31, an organic emission layer 48 formed on the first electrode lines 42, and a plurality of second electrode lines 44 arranged in a predetermined pattern and formed on the organic emission layer 48.

The substrate 31 may be made of glass, acryl, polyimid, polycarbonate, polyester, mylar, plastic, metal, or the like, but is not limited thereto. A buffer layer may be formed on the substrate 31 to prevent the diffusion of impurity ions, if needed. Additionally, a barrier layer may be formed on the substrate 31 to prevent leaking of water or air.

The first electrode lines 42 may be made of TTO, IZO, ZnO, or In₂O₃, but they are not limited thereto. The second electrode lines 44 may be made of Ag, Mg, Al, Pt, Pd, Au, Ni, Nd, Ir, Cr, or a compound of these, but they are not limited thereto. A portion of the organic emission layer 48 between a first electrode line 42 and a second electrode line 44 emits light, thus forming a predetermined image.

Any organic layer that is commonly used in an organic light emitting display device can be used as the organic emission layer 48. The organic emission layer 48 may be made of a low molecular weight material or a polymer material.

When the organic emission layer 48 is made of low molecular weight material, the organic emission layer 48 may comprise a hole injection layer (HIL), a hole transport layer (HTL), an emission layer (EML), an electron transport layer (ETL), an electron injection layer (EIL), a combination of these, or the like. An organic material comprising the organic layer may be copper phthalocyanine (CuPc), N,N'-Di(naphthalene-l-yl)-N,N'-diphenyl-benzidine (NPB), tris-8-hydroxyquinoline (Alq3), or the like. In this case, for example, a vacuum deposition method can be used to form the low molecular weight organic layer.

When the organic emission layer 48 is made of polymer material, the organic emission layer 48 may include the HTL and the EML. The HTL may be made of PEDOT, and the EML may be made of poly-phenylenevinylene (PPV), polyfluorene, or the like. In this case, for example, screen printing or inject printing may be used to form the polymer organic layer.

The organic emission layer 48 can be formed into various patterns, corresponding to the color of a pixel.

Descriptions of the first electrode lines 42, the second electrode lines 44, and the organic emission layer 48 are the same in the embodiments of the present invention.

The emission unit 40 may further include an inner insulating layer 46 formed below the organic emission layer 48. The inner insulating layer 46 insulates the first electrode lines 42 from each other, and it also insulates the first electrode lines 42 from the second electrode lines 44 in a non-emission area. The inner insulating layer 46 may comprise an insulating material, such as a photosensitive polyimide, or the like, and it may be formed using photolithography. The inner insulating layer 46 may have a striped pattern, a lattice pattern, or the like.

Referring to FIG. 3, the terminals 50 include first electrode terminals 52 and second electrode terminals 54 that are disposed along edges ofthe substrate 31. Specifically, the first electrode terminals 52 may be disposed on one edge of the substrate 31, and the second electrode terminals 54 may be disposed on other, opposite edges of the substrate 31. However, the configuration ofthe first and second electrode terminals 52 and 54 is not limited thereto. For example, the first electrode terminals 52 and the second electrode terminals 54 can be disposed on the same edge ofthe substrate 31.

Referring to FIG. 6, the second electrode terminal 54 includes a lower first conducting layer 54a and an upper second conducting layer 54b. The first conducting layer 54a may be made of, for example, ITO, IZO, ZnO, or In₂O₃, which is similar to the first electrode line 42. The second conducting layer 54b may be made of, for example, Ag, Mg, Al, Pt, Pd, Au, Ni, Nd, Ir, Cr, or a compound of these. The second electrode line 44 extends from the emission unit 40 to the second electrode terminal 54. Although not shown in the drawings, the first electrode terminal 52 may have the same configuration as the second electrode terminal 54. In this case, a first conducting layer of the first electrode terminal 52 and the first electrode line 42 can be integrated in one body.

The organic light emitting display device may further include an outer insulating layer 56 comprising an insulating material interposed between the emission unit 40 and at least the second electrode terminal 54. The outer insulating layer 56 may be formed by extending a portion of the inner insulating layer 46 from the first electrode line 42a, which is disposed at an edge of the emission unit 40, to the second electrode terminal 54. In this case, the outer insulating layer 56 may contact an edge ofthe second electrode terminal 54 disposed toward the emission unit 40. In other words, the emission unit 40 may be connected to the second electrode terminal 54. According to an exemplary embodiment of the present invention, as illustrated in FIG. 6, the outer insulating layer 56 may overlap the edge of the second electrode terminal 54 that is disposed toward the emission unit 40. The outer insulating layer 56 may decrease a step difference between the second electrode terminal 54 and the upper surface of the substrate 31. Therefore, when a second electrode interconnecting line 45, which is electrically connected to the second electrode line 44, extends to an upper surface of the second electrode terminal 54, a short-circuit due to the step difference may be prevented.

A portion ofthe outer insulating layer 56 covering the edge ofthe second electrode terminal 54 has a contact hole 57. The second electrode interconnecting line 45 may be coupled to the second electrode terminal 54 through the contact hole 57.

The contact hole 57 may expose the second conducting layer 54b of the second electrode terminal 54.

The contact hole 57 includes a contact resistance controlling portion 58 to decrease a contact resistance between the second electrode terminal 54 and the second electrode interconnecting line 45 and maintain it at a predetermined level.

As FIG. 4 shows, the contact resistance controlling portion 58 may include an inlet portion 58a formed in the second conducting layer 54b.

The inlet portion 58a may be formed in the second conducting layer 54b such that a portion of the first conducting layer 54a is exposed by the contact hole 57 and the inlet portion 58a. Therefore, currents flowing in the second electrode interconnecting line 45 and the second electrode terminal 54 may be focused in the inlet portion 58a, thus decreasing the contact resistance.

As illustrated in FIG. 4, the inlet portion 58a may comprise a recess in at least a part of the second conducting layer 54b exposed by the contact hole 57. The inlet portion 58a can be formed with other shapes than that shown. For example, the inlet portion 58a can be formed with a wavelike shape.

The inlet portion 58a can be formed even when the second electrode interconnecting line 45 contacts the second electrode terminal 54 without the outer insulating layer 56. That is, the inlet portion 58a may be formed at a point of contact between the second electrode interconnecting line 45 and the second electrode terminal 54 so that currents may be focused in the inlet portion 58a, thus decreasing the contact resistance.

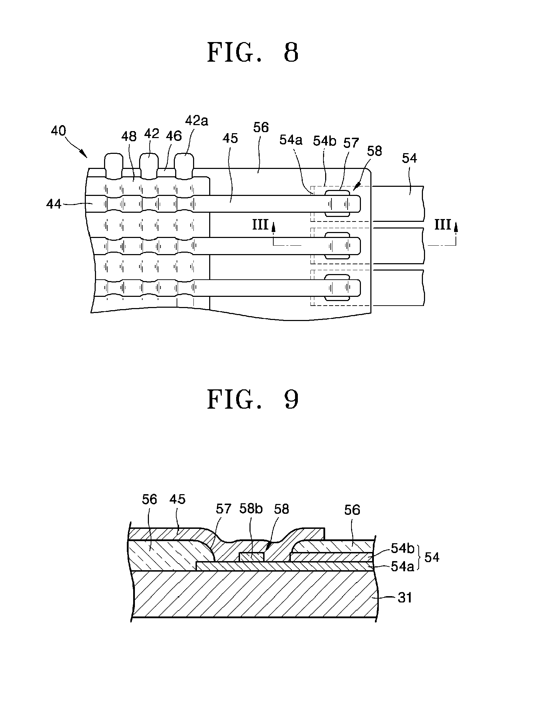

FIG. 7, FIG. 8 and FIG. 9 illustrate a contact resistance controlling portion 58 according to another exemplary embodiment ofthe present invention. FIG. 7 is an enlarged plan view of a contact resistance controlling portion "A" of FIG. 3 according to an exemplary embodiment of the present invention before forming a second electrode line. FIG. 8 shows FIG. 7 after forming the second electrode line, and FIG. 9 is a sectional view taken along line III-III of FIG. 8. Referring to FIG. 7, FIG. 8 and FIG. 9, the contact resistance controlling portion 58 may include a structure 58b with a predetermined shape formed on a portion of the second electrode terminal 54 where it overlaps with the second electrode interconnecting line 45. The contact hole 57 may expose the structure 58b, and the second electrode interconnecting line 45 may cover the structure 58b while contacting the second electrode terminal 54.

The structure 58b may comprise various materials. For example, the structure 58b and the outer insulating layer 56 may be made ofthe same materials, and the structure 58b and the contact hole 57 can be patterned at the same time.

Similar as above, currents may be focused at the structure 58b, thus decreasing a contact resistance between the second electrode interconnecting line 45 and the second electrode terminal 54.

The shape of the structure 58b is not limited to the shape shown in FIG. 7 and FIG. 9. In other words, the structure 58b can have various shapes. For example, the structure 58b may have a cylindrical shape.

Additionally, as described above, the structure 58b can be formed where the second electrode interconnecting line 45 overlaps the second electrode terminal 54 even when the second electrode interconnecting line 45 contacts the second electrode terminal 54 without the outer insulating layer 56. Therefore, currents may be focused at the structure 58a, thus decreasing the contact resistance.

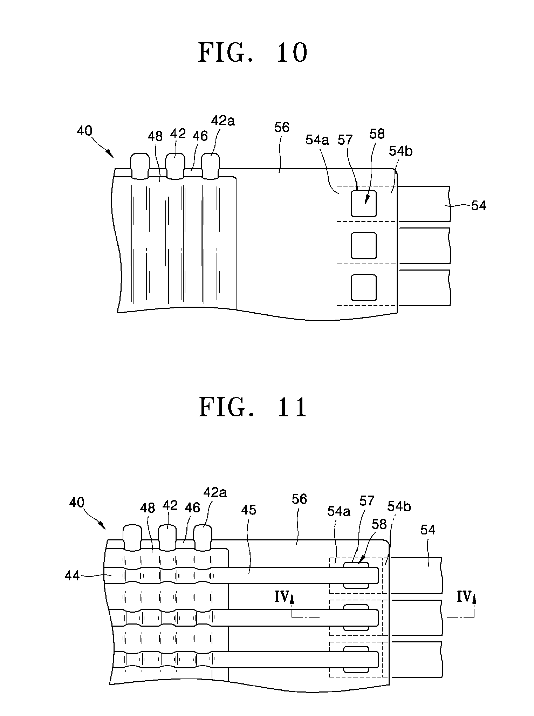

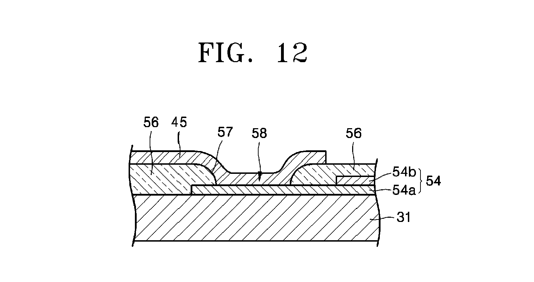

FIG. 10, FIG. 11 and FIG. 12 illustrate a contact resistance controlling portion 58 according to another exemplary embodiment of the present invention. FIG. 10 is an enlarged plan view of a contact resistance controlling portion "A" of FIG. 3 according to an exemplary embodiment of the present invention before forming a second electrode line. FIG. 11 shows FIG. 10 after forming the second electrode line, and FIG. 12 is a sectional view taken along line IV-IV of FIG. 11. Referring to FIG. 10, FIG. 11 and FIG. 12, the contact resistance controlling portion 58 may be formed such that the contact hole 57 exposes a portion of the first conducting layer 54a. In this case, the first conducting layer 54a of the second electrode terminal 54 may have better cleaning characteristics than the second conducting layer 54b ofthe second electrode terminal 54.

The first conducting layer 54a may be made of a conducting oxide, such as, for example, ITO, IZO, ZnO, or In₂O₃, and the second conducting layer 54b may be made of a metal, such as, for example, Ag, Mg, Al, Pt, Pd, Au, Ni, Nd, Ir, or Cr. Here, the first conducting layer 54a may have better cleansing characteristics than the second conducting layer 54b during a cleansing process, such as cleansing with oxygen plasma, or a UV cleansing. In other words, impurities existing on the first conducting layer 54a, which comprises an oxide, may be more easily removed than impurities existing on the metallic second conducting layer 54b.

Therefore, as illustrated in FIG. 10, FIG. 11 and FIG. 12, the second electrode interconnecting line 45 contacts the first conducting layer 54a such that the contact resistance between the second electrode interconnecting line 45 and the second electrode terminal 54 may decrease.

As described above, the contact resistance controlling portion 58 may decrease the contact resistance between the second electrode interconnecting line 45 and the second electrode terminal 54. However, embodiments of the present invention can also be used for any interconnecting line that extends from the emission unit 40 to contact a terminal outside the emission unit 40.

Additionally, although the organic light emitting display devices shown are passive matrix types, embodiments of the present invention may also be used to form active matrix-type organic light emitting display devices.

In an active matrix-type organic light emitting display device, a pixel electrode may be formed in each pixel and a counter electrode may be commonly patterned for all pixels instead of first and second electrodes of an emission unit, respectively.

In this case, a contact resistance controlling portion can be used between the counter electrode and a terminal thereof Further, the contact resistance controlling portion can be used between scan, data, VDD interconnecting lines and terminals thereof

The exemplary embodiments of the present invention may provide the following effects.

First, an inlet portion may formed where an interconnecting line contacts a terminal such that currents may be focused in the inlet portion, thereby decreasing a contact resistance.

Second, a structure may be formed where the interconnecting line contacts the terminal such that currents may be focused at the structure, thereby decreasing the contact resistance.

Third, the portion where the interconnecting line contacts the terminal may have excellent cleansing characteristics, thereby permitting decreased contact resistance.

Fourth, lower contact resistance between the electrode interconnecting line and the terminal may result in a lower driving voltage. Therefore, signals may become more uniform.

It will be apparent to those skilled in the art that various modifications and variation can be made in the present invention without departing from the spirit or scope of the invention. Thus, it is intended that the present invention cover the modifications and variations of this invention provided they come within the scope ofthe appended claims and their equivalents.

## Claims

1. A light emitting display device, comprising:
a substrate;
an emission unit that forms an image and is disposed on the substrate;
a first conductor which contacts a second conductor that is electrically connected to the emission unit; and
a contact resistance controlling portion which decreases a contact resistance between the first conductor and the second conductor and is located where the first conductor contacts the second conductor.

2. The light emitting display device of claim 1, wherein
the contact resistance controlling portion comprises an inlet portion formed in the first conductor; and
the second conductor covers the inlet portion.

3. The light emitting display device of claim 2, wherein
the first conductor comprises at least two conducting layers; and
the inlet portion is formed in a conducting layer contacting the second conductor.

4. The light emitting display device of claim 3, wherein
the second conductor contacts the conducting layers in the inlet portion.

5. The light emitting display device of claim 2, further comprising:
an insulating layer which covers an edge of the first conductor, comprises a contact hole through which the second conductor contacts the first conductor, and is disposed between the emission unit and the first conductor and between the second conductor and the substrate,
wherein the inlet portion is formed in a portion of the first conductor exposed by the contact hole.

6. The light emitting display device of claim 1, wherein
the contact resistance controlling portion comprises a structure formed on the first conductor at a portion where the second conductor and the first conductor contact each other, and
the second conductor covers the structure.

7. The light emitting display device of claim 6, wherein the structure comprises an insulating material.

8. The light emitting display device of claim 6, further comprising:
an insulating layer which covers an edge of the first conductor, comprises a contact hole through which the second conductor contacts the first conductor, and is disposed between the emission unit and the first conductor and between the second conductor and the substrate,
wherein the structure is exposed by the contact hole.

9. The light emitting display device of claim 1, further comprising:
an insulating layer which covers an edge of the first conductor, comprises a contact hole through which the second conductor contacts the first conductor, and is disposed between the emission unit and the first conductor and between the second conductor and the substrate,
wherein the first conductor comprises at least two conducting layers and in the contact resistance controlling portion, a conducting layer having better cleansing characteristics than the other conducting layer is exposed by the contact hole.

10. The light emitting display device of claim 9, wherein
the first conductor comprises a metal layer and a conducting oxide layer; and
the conducting oxide layer is exposed by the contact hole.

11. The light emitting display device of claim 10, wherein the conducting oxide layer comprises ITO, IZO, In₂O₃, or ZnO, and the metal layer comprises Cr, Ag, Mg, Al, Pt, Pd, Au, Ni, Nd, or Ir.

12. The light emitting display device of claim 1, wherein the emission unit comprises a lower electrode formed on the substrate, an upper electrode facing the lower electrode, and an emission layer interposed between the lower electrode and the upper electrode, and a lower electrode second conductor and an upper electrode second conductor are electrically connected
